# EUROPÄISCHE PATENTSCHRIFT

(11) **EP 3 855 190 B1**
(45) Veröffentlichungstag und Bekanntmachung des Hinweises auf die Patenterteilung: **19.03.2025**
(21) Anmeldenummer: 20153861.8
(22) Anmeldetag: 27.01.2020
(51) Int. Cl.: G01H 11/00, G01H 3/06, G01R 19/15, G01R 19/155

(54) **SCHALLBASIERTE STROMMESSUNG**
SOUND-BASED CURRENT MEASUREMENT
MESURE DE COURANT BASÉE SUR LE SON

(43) Veröffentlichungstag der Anmeldung: 28.07.2021
(73) Patentinhaber: Navispace GmbH, 82211 Herrsching (DE)
(72) Erfinder: STAMMEL, Christian, 82211 Herrsching (DE)
(74) Vertreter: Samson & Partner Patentanwälte mbB

(56) Entgegenhaltungen:
- EP-A1- 2 996 157
- WO-A1-2016/037897
- WO-A1-2016/167669
- US-A1- 2017 045 571
- US-A1- 2018 322 764

## Beschreibung

Die vorliegende Erfindung betrifft ein Verfahren sowie eine Vorrichtung zum Messen von elektrischem Strom und/oder elektrischer Spannung.

### Hintergrund

Der Umgang mit elektrischem Strom oder elektrischer Spannung kann mit erheblichen gesundheitsgefährdenden, zum Teil tödlichen Gefahren verbunden sein. Insbesondere Fachpersonal wie Elektrofachkräfte sind im täglichen Umgang mit elektrischen Bauelementen und anderen stromführenden Bauteilen einem erhöhten Gefährdungspotential ausgesetzt.

Aus dem Stand der Technik sind elektrische Ortungsgeräte wie Leitungssucher bekannt, welche in Wänden verborgene Stromleitungen detektieren. Dies hilft unter anderem zu verhindern, dass beispielsweise beim Bohren von Löchern in Wänden unerwartet auf eine Leitung getroffen wird und es infolgedessen zu einem Stromunfall kommen kann.

Ein Ortungsgerät (auch als Leitungssucher, Leitungsfinder, Balkenfinder oder Multidetektor bekannt) dient, insbesondere im Rahmen der Haustechnik, der Lokalisierung von nicht sichtbaren Objekten innerhalb von Wänden, Decken und Böden wie elektrischen Leitungen, aber auch Wasser- und Gasleitungen, Moniereisen, oder Ständerkonstruktionen. Die Detektion fußt bei Ortungsgeräten auf folgenden Prinzipien:
- Messung der passiven elektromagnetischen Induktion bei mit Wechselstrom durchflossenen Leitern;
- aktives Erzeugen eines Magnetfeldes und Prüfung der Signalantwort bei Metallen (induktive Messung);
- aktives Erzeugen eines elektrischen Feldes und Prüfung der Signalantwort (kapazitive Messung). Mit diesem Verfahren können auch Nichtmetalle geortet werden;
- aktives Erzeugen elektromagnetischer Wellen im Radiofrequenzbereich und Prüfung der Signalantwort. Diese Geräte können auch gefüllte und leere Kunststoffrohre erkennen;

Stromortungsgeräte bzw. Spannungsortungsgeräte können mehrere der vorgenannten Prinzipien zur Ortung anwenden.

Zu weiteren Strommessgeräten bzw. Spannungsmessgeräten, welche elektrische Ströme aufgrund der von diesen erzeugten elektromagnetischen Feldern messen, sind u. a. Stromsensoren sowie Zangenstrommesser zu zählen.

EP 2 996 157 A1 beschreibt ein Verfahren und eine Vorrichtung zum Detektieren von Lichtbögen in einer Photovoltaikanlage mit einem Wechselrichter und mit mehreren, über Sammelleitungen an den Wechselrichter parallel angeschlossenen Stromsammeleinheiten. An jeder Stromsammeleinheit sind mehrere Strings von Photovoltaikmodulen über Stringleitungen parallel angeschlossen. Messwerte elektrischer Größen werden an mindestens einer der Stringleitungen jedes Strings und/oder an mindestens einer Vorsammelleitung jedes Paars von Vorsammelleitungen, an das mehrere Strings parallel angeschlossen sind, und/oder an mindestens einer der Sammelleitungen von jeder Stromsammeleinheit in den Stromsammeleinheiten und Messwerte akustischer Größen an mindestens einer Sammelleitung von jeder Stromsammeleinheit und/oder an mindestens einer dem Wechselrichter zugeordneten Stromsammelschiene, an die eine Sammelleitung von jeder Stromsammeleinheit angeschlossen ist, erfasst. Die Messwerte der elektrischen und akustischen Größen werden auf das Vorliegen von Hinweisen auf einen Lichtbogen in der Photovoltaikanlage analysiert; und ein Lichtbogensignal wird generiert, wenn die vorliegenden Hinweise auf den Lichtbogen vorgegebene Kriterien erfüllen.

WO 2016/167669 A1 offenbart ein computerimplementiertes Verfahren zur Feststellung, dass ein elektrischer Zaun unter Spannung steht, wobei das Verfahren den Empfang von Daten, die für die Stärke eines in der Nähe des elektrischen Zauns über einen bestimmten Zeitraum erfassten Signals repräsentativ sind, und die Analyse dieser Daten umfasst, um eine Reihe von Impulsen in dem Signal zu identifizieren, die anzeigen, dass der elektrische Zaun unter Spannung steht. Darüber hinaus wird eine Vorrichtung zum Erkennen, dass ein Elektrozaun unter Strom steht, offenbart. Die Vorrichtung umfasst Mittel zum Empfangen eines Signals, das über einen bestimmten Zeitraum aus der Ferne von einem Elektrozaun erfasst wird, sowie Mittel zum Analysieren des Signals, um festzustellen, ob der Elektrozaun unter Strom steht. Außerdem wird eine periphere Vorrichtung zur Erfassung eines von einer elektrischen Feldquelle erzeugten elektrischen Feldes offenbart.

US 2018/322764 A1 beschreibt ein rechnergestütztes Überwachungssystem und Verfahren zur Erkennung von Ausfällen elektrischer Geräte. Das System umfasst einen Sensor, der einen Schallpegel erfasst, der für Ultraschallemissionen repräsentativ ist, die von der zu überwachenden elektrischen Anlage ausgehen. Ein Computersystem, das mit dem Sensor in Verbindung steht, ist so programmiert, dass es auf der Grundlage des vom Sensor erfassten Schallpegels feststellt, ob die elektrische Anlage einen oder mehrere Lichtbögen, eine Verfolgung oder eine Korona aufweist. In einigen Ausführungsformen überwacht das Computersystem kontinuierlich diese Zustände auf der Grundlage des vom Sensor erfassten Schallpegels.

US 2017/045571 A1 beschreibt ein System, dass unnötige Interventionen von Stromversorgern und Ersthelfern im Falle eines heruntergefallenen elektrischen Kabels, das möglicherweise keine Spannungsgefahr darstellt, verringert. Das beschriebene System zur Anzeige des Zustands einer ausgefallenen Stromleitung dient dem Schutz der Öffentlichkeit und erhöht gleichzeitig die Fähigkeit, Leitungen zu reparieren, die durch eine ungeplante Naturkatastrophe oder einen anderen Vorfall beschädigt wurden. Der Status einer ausgefallenen Leitung kann erfasst werden und, wenn diese unter Spannung steht, einen lokalen visuellen und akustischen Alarm über gefährliche Bedingungen für jeden in der Nähe der ausgefallenen Leitung bereitstellen. Darüber hinaus kann eine Nachricht oder Benachrichtigung an die Betriebszentrale des Versorgungsunternehmens gesendet werden.

Der Nachteil von Stromessverfahren und Spannungsmessverfahren, die auf elektromagnetischen Feldern basieren ist die Empfindlichkeit auf elektromagnetische Stör- und Streufelder, welche beispielsweise von benachbarten elektrischen Leitern ausgehen. Teilweise kann dieser Nachteil ausgeglichen werden, indem die Sensoren an genau definierten Positionen eingesetzt werden, beispielsweise derart, dass Streufelder nicht axial wirken. Oft ist dies jedoch aus konstruktiven oder räumlichen Gründen schwierig und setzt zudem bereits Kenntnisse über einen genauen Verlauf von elektrischen Leitern voraus. Eine rechtzeitige und zuverlässige Detektion von unerwartet auftretenden elektrischen Strömen und/oder Spannungen, um beispielsweise arbeitendes Personal zu warnen, ist unter den vorgenannten Bedingungen nicht möglich.

Die bezeichneten Probleme im vorgenannten Stand-der-Technik werden durch die anspruchsgemäßen Verfahren und Vorrichtungen gelöst.

### Zusammenfassung

Gemäß einem ersten Aspekt umfasst die Erfindung ein Verfahren zum Detektieren eines Vorhandenseins eines elektrischen Stroms und/oder einer elektrischen Spannung, wobei das Verfahren das Bereitstellen eines Detektionsmittels umfasst, um einen mit dem Vorhandensein des elektrischen Stroms und/oder elektrischen Spannung verbundenen physikalischen Effekt zu detektieren. Das Verfahren umfasst weiter das Bereitstellen eines Auswertemittels, um ein bei Vorhandensein eines elektrischen Stromes und/oder elektrischen Spannung erzeugtes Detektionssignal in ein Auswertesignal umzuwandeln sowie das Bereitstellen eines Ausgabemittels, um das Auswertesignal in ein Ausgabesignal umzuwandeln. Erfindungsgemäß umfasst das Verfahren die Detektion eines mit dem Vorhandensein des elektrischen Stromes und/oder der elektrischen Spannung verbundenen Schalls. Erfindungsgemäß umfasst der Schall Körperschall und das Verfahren eine berührungslose Detektion. Erfindungsgemäß sind das Detektionsmittel und das Ausgabemittel von einem tragbaren Gerät umfasst.

In einer Ausführungsform umfasst der Schall Schallwellen in einem festen und/oder flüssigen und/oder gasförmigen Trägermedium.

In einer besonderen Ausführungsform umfasst der Körperschall den an einem elektrischen Leiter hervorgerufenen Körperschall, wobei der elektrische Leiter von dem elektrischen Strom durchflossen wird.

In einer weiteren Ausführungsform umfasst die Detektion des mit dem Vorhandensein des elektrischen Stroms und/oder einer elektrischen Spannung verbundenen physikalischen Effektes die Detektion eines elektromagnetischen und/oder elektrischen und/oder magnetischen Feldes.

In einer Ausführungsform wird als Detektionsmittel ein Mikrophon und/oder ein Mikrosystem und/oder als Ausgabemittel ein Lautsprecher und/oder Bildschirm und/oder Leuchtmittel und/oder Mittel zum Erzeugen eines haptischen Signals bereitgestellt.

In einer Ausführungsform wird das Auswertesignal drahtlos gesendet, übertragen und empfangen und/oder das Auswertesignal umfasst eine berechnete Stromstärke und/oder berechnete Stromspannung und/oder eine berechnete elektrische und/oder magnetische Feldstärke und/oder eine berechnete elektrische und/oder magnetische Flussdichte und/oder das Ausgabesignal umfasst ein Schallsignal und/oder ein optisches Signal und/oder ein Textsignal und/oder ein haptisches Signal.

Gemäß einem zweiten Aspekt umfasst die Erfindung ein Tragbares Gerät umfassend eine Vorrichtung zum Detektieren eines Vorhandenseins eines elektrischen Stroms und/oder einer elektrischen Spannung gemäß Anspruch 7.

In einer Ausführungsform umfasst das Detektionsmittel ein Mikrophon und/oder ein Mikrosystem. Das Ausgabemittel umfasst einen Lautsprecher und/oder Bildschirm und/oder Leuchtmittel und/oder Mittel zum Erzeugen eines haptischen Signals.

In einer Ausführungsform sind das Auswertemittel und das Ausgabemittel so eingerichtet, das Auswertesignal drahtlos zu senden, zu übertragen und zu empfangen und/oder eine Stromstärke und/oder eine Stromspannung und/oder eine elektrische und/oder magnetische Feldstärke und/oder eine elektrische und/oder magnetische Flussdichte zu berechnen. Das Ausgabemittel ist so eingerichtet, als Ausgabesignal ein Schallsignal und/oder ein optisches Signal und/oder ein Textsignal und/oder ein haptisches Signal zu erzeugen.

Gemäß einem dritten Aspekt umfasst die Erfindung eine Arbeitsschutzvorrichtung zum Ausgeben eines Warnsignals, umfassend die Vorrichtung nach einem der vorhergehenden Ausführungsformen, wobei das Warnsignal das Ausgabesignal nach einem der vorhergehenden Ausführungsformen umfasst

Im Folgenden wird die Erfindung anhand der Zeichnungen in ihrem Aufbau und in ihrer Wirkungsweise näher erläutert.
Figur 1 zeigt ein erfindungsgemäßes Leitersystem 1 unter Einwirkung eines elektromagnetischen Feldes.
Figur 2 zeigt schematisch eine Hochspannungsleitung mit Leiterseilen unter Wirkung eines elektromagnetischen Feldes.
Figur 3 zeigt schematisch die an Hochspannungsleitungen auftretenden Koronarentladungen.
Figur 4 zeigt schematisch an einer Hochspannungsleitung kondensierte Wassertropfen.
Figur 5 zeigt schematisch ein Leitersystem zum Leiten eines elektrischen Stromes.
Figur 6 zeigt die erfindungsgemäße schallbasierte Detektion eines elektrischen Stromes.
Figur 7 zeigt eine erfindungsgemäße Umwandlung eines Detektionssignals sowie ein erfindungsgemäßes Auswertemittel und ein erfindungsgemäßes Ausgabemittel.
Figur 8 zeigt ein Auswertemittel und ein Ausgabemittel gemäß einer besonderen Ausführungsform der Erfindung.
Figur 9 zeigt die erfindungsgemäße Detektion von an einen Leitersystem kondensierten Wassertropfen.
Figur 10 zeigt die erfindungsgemäße Detektion eines Defektes an einem Leitersystems.
Figur 11 zeigt ein erfindungsgemäßes Sicherheitssystem.

### Detaillierte Beschreibung bevorzugter Ausführungsbeispiele

Die Erfindung betrifft ein Verfahren und eine Vorrichtung zum Detektieren eines Vorhandenseins eines elektrischen Stroms und/oder einer elektrischen Spannung.

Elektrische Ströme, insbesondere elektrische Wechselströme können auf mehrere Arten als Quelle von Schallemission fungieren, wie nachfolgend beschrieben wird.

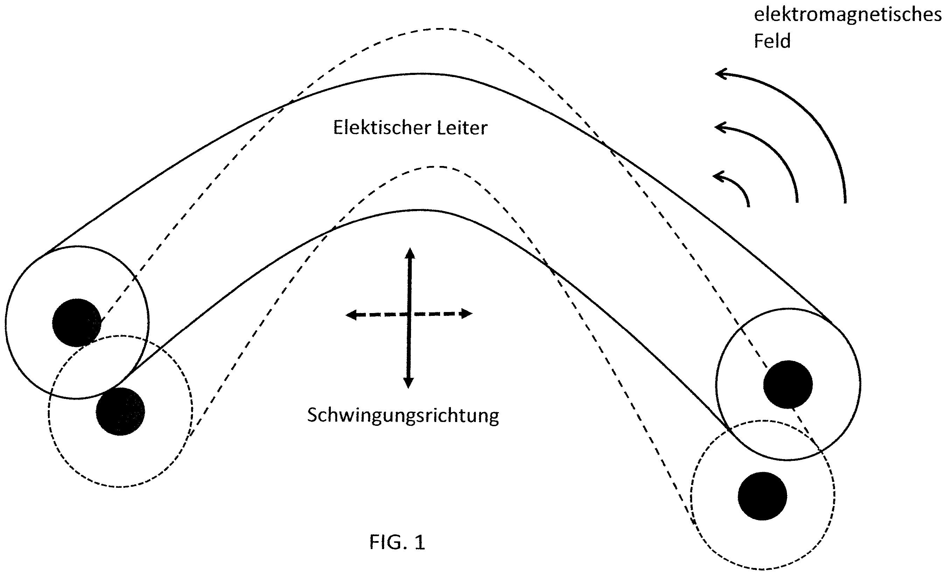

Eine Art, Schall zu erzeugen beruht auf der Deformation magnetischer, beispielsweise ferromagnetischer Stoffe infolge des durch den elektrischen Strom erzeugten magnetischen Feldes. Dieses als Magnetostriktion bekannte Phänomen lässt Körper bei konstanten Volumen elastische Wellenlängenänderungen erfahren. Dies ist schematisch in FIG. 1 dargestellt, in welcher ein elektrischer Leiter, dessen Form unabhängig von der Darstellung in FIG. 1 als beliebig angenommen werden kann, unter der Einwirkung eines durch elektrischen Strom hervorgerufenen elektromagnetischen Feldes elastischen Verformungen unterworfen ist. Die Ursache für dieses Phänomen ist quantenmechanischer Natur. So erfährt etwa ein Eisenleiter eines Transformators derartige Schwingungen, welche in der umgebenden Luft Schallwellen erzeugen und somit das charakteristische Brummen eines Transformators verursachen.

Die Frequenz, mit der ein elektrischer Leiter unter Einwirkung eines elektromagnetischen Feldes schwingt, ist bestimmt durch die mechanische Struktur des Leiters. Ändert sich diese Struktur, etwa durch Umbau oder Beschädigung, so wird der Leiter mit einer anderen Frequenz schwingen. Die Frequenz des emittierten Schalls ändert sich somit ebenfalls.

Ein zur Magnetostriktion analoger Effekt ist die Elektrostriktion und beschreibt die Deformation eines dielektrischen Mediums in Abhängigkeit eines angelegten elektrischen Feldes. Dieser Effekt tritt beispielsweise bei elektrischen Kondensatoren auf und kann ebenfalls als Quelle akustischen Schalls fungieren.

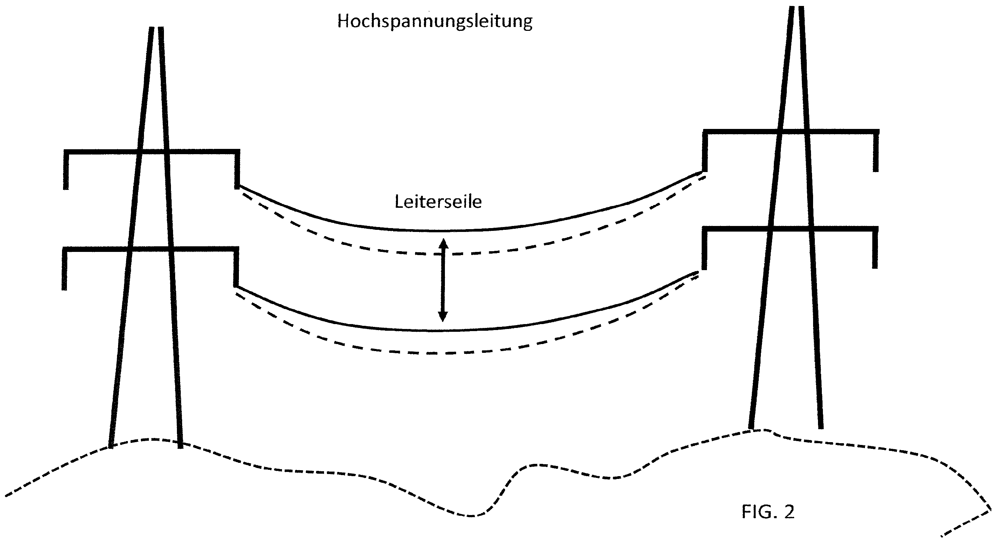

Weitere Schallquellen, insbesondere bei Hochspannungsleitungen sind die Schwingungen der Leiterseile, hervorgerufen durch elektromagnetische Felder (FIG. 2), des Weiteren die Koronarentladungen sowie die Bewegung von an den Leitungen kondensierten Wassertropfen infolge elektromagnetischer Felder. Die beiden letztgenannten Effekte treten vornehmlich bei erhöhter Luftfeuchtigkeit auf.

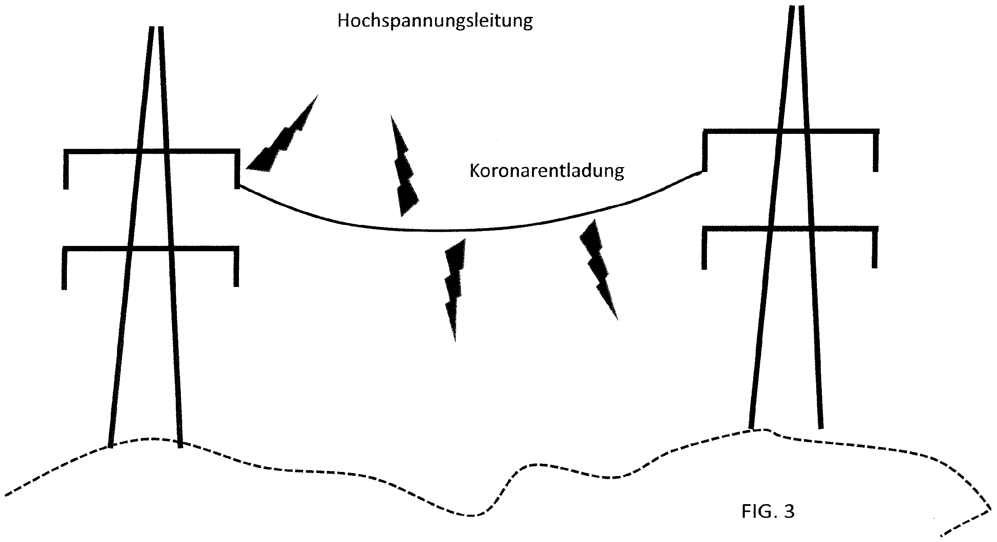

Bei den Koronarentladungen, schematisch dargestellt in FIG. 3, handelt es sich um elektrische Entladungen um die stromführenden Seile herum, wobei Ionen als Ladungsträger fingieren, die sich in der Regel in der Luft infolge von Feldionisation bilden. Dabei werden kleine, in der Regel nicht sichtbare Blitze erzeugt und ist mit einen für gewöhnlich als Knistern oder Zischen wahrnehmbaren Geräusch verbunden. Begünstigt werden solche Entladungen an Stellen mit scharfen Kanten oder Spitzen, da hier eine besonders hohe elektrische Feldstärke auftritt.

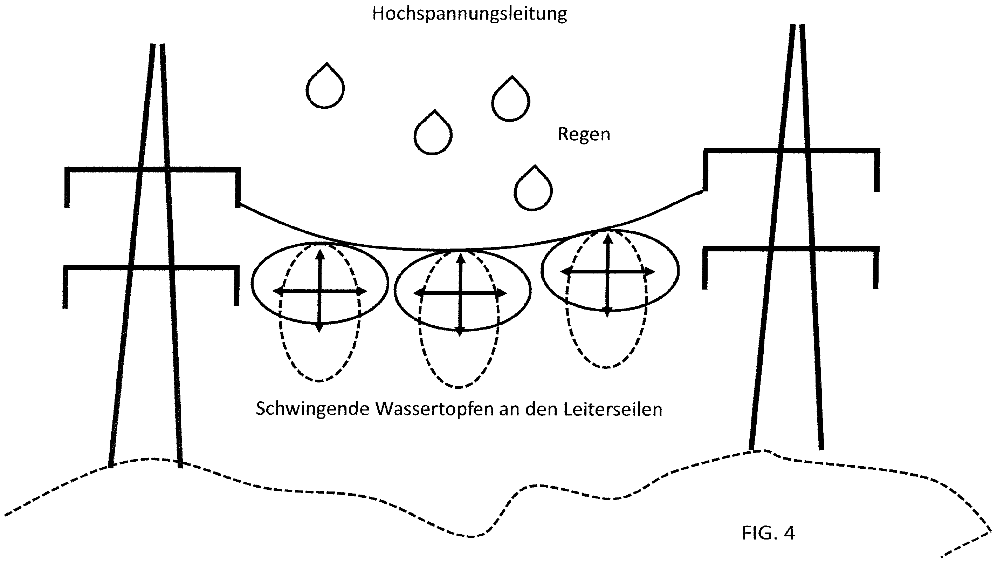

Bilden sich etwa bei Regen, Nebel oder Schneefall Wassertropfen an den Leitungen, wie in FIG. 4 dargestellt, schwingen diese mit einer Frequenz, die dem doppelten der Leitungsfrequenz entspricht. Während die Wassertropfen schwingen, verändern sie sich in ihrer Gestalt und wirken somit als Schallquelle.

Die Entwicklung von leistungsfähigen Schallsensoren, insbesondere auf dem Gebiet der mikroelektromechanischen Sensoren (MEMS-Sensoren) hat es in den letzten Jahren ermöglicht, auch Schallemission auf einem extrem niedrigen Intensitätsniveau zu detektieren, sowie das Spektrum des zu detektierenden Schalls auf Infraschall und Ultraschall auszuweiten. Zudem ermöglichen es neue und verbesserte Methoden zur Frequenzanalyse, die in gemessenen Schall enthaltenen Schwingungsfrequenzen zu ermitteln und daraus Rückschlüsse auf die Schallquellen, z. B. bewegte Teile von Maschinen, zu ziehen.

Eine schallbasierte Messung und Überwachung von elektrischen Strömen stellt somit eine weitere und neue Möglichkeit dar, elektrische Ströme berührungslos zu detektieren und zu messen und die bestehenden, auf elektromagnetischen Feldern basierenden Methoden zu ergänzen und den vorgenannten Nachteil der Empfindlichkeit von elektromagnetischen Streufeldern zumindest teilweise zu kompensieren, ohne hierbei auf konstruktive und räumliche Randbedingungen eingehen zu müssen und zudem bereits Kenntnisse über einen Verlauf einer elektrischen Leitung besitzen zu müssen.

Zudem stellt die schallbasierte Stromdetektion und -messung eine Ergänzung für die Zustandsüberwachung von Maschinen dar, insbesondere dann, wenn diese Maschinen Komponenten umfassen, welche von elektrischem Strom durchflossen werden. Im Stand-der-Technik werden bereits schallbasierte Verfahren zur Zustandsüberwachung zum Monitoring bewegter, insbesondere rotierender Maschinenteile, wie etwa Kugelgewinde eingesetzt. Mechanische Bewegungen von Teilen, hervorgerufen durch die Wirkung elektromagnetischer Felder, die von stromdurchflossenen Leitern ausgehen, werden hingegen bisher von der Zustandsüberwachung nicht erfasst.

Eine schallbasierte Detektion von elektrischen Strömen stellt auch eine Ergänzung in Sicherheitssystemen zur Warnung vor unerwartet auftretenden elektrischen Strömen dar. Beispielsweise könne auf diese Weise Systeme ergänzt werden, welche die Lage von abgerissenen Hochspannungsseilen in unübersichtlichen Geländeverhältnissen wie Böden mit hochwachsender Vegetation ermitteln.

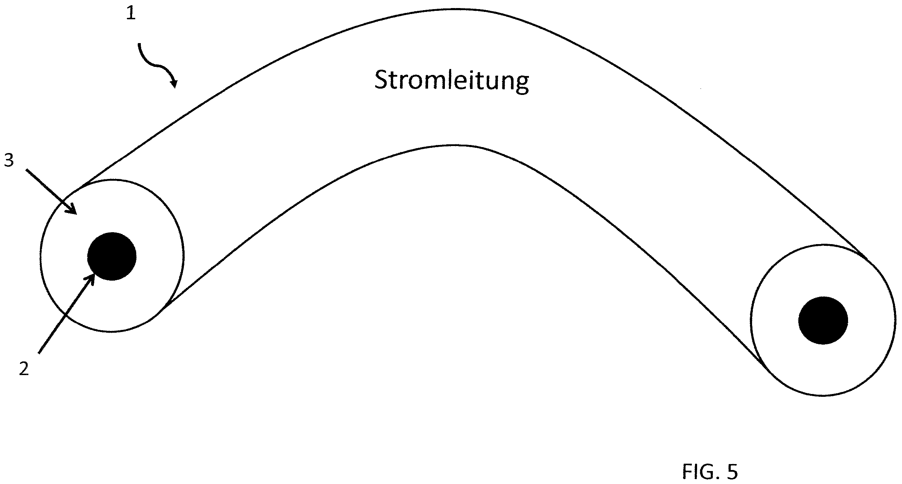

Der elektrische Strom kann in einem elektrischen Leiter fließen. FIG. 5 veranschaulicht einen elektrisches Leitersystem 1, umfassend einen elektrisch leitfähigen Leiter 2, der beispielhaft als elektrisch leitfähige Ader eines Kabels, als Wicklung oder Spule aus elektrisch leitfähigen Drähten oder als elektrische Leiterbahnen auf einer Platine ausgeführt sein kann. Das Leitersystem 1 kann weiterhin eine Ummantelung 3 um den Leiter 2 umfassen, wobei die Ummantelung 3 eine oder mehrere Schichten elektrisch isolierender Materialien umfassen kann. Die Ummantelung 3 kann diamagnetische, paramagnetische oder ferromagnetische Materialien umfassen. Die Ummantelung 3 kann mit dem Leiter 2 nicht in direktem Kontakt stehen und kann beispielsweise Bestandteil von anderen, den Leiter 2 umgebende Komponenten einer Maschine sein.

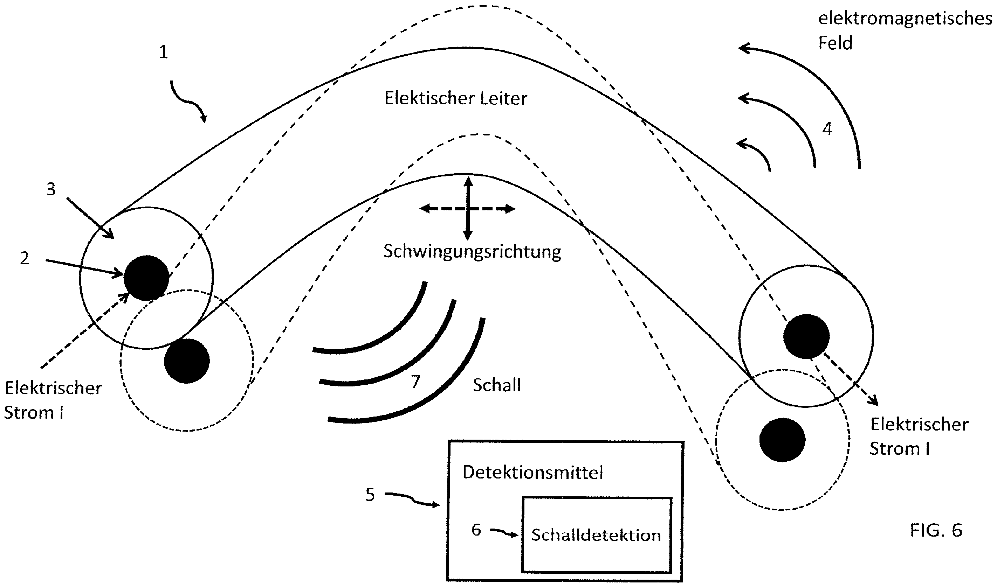

Fließt, wie in FIG. 6 dargestellt, ein elektrischer Strom mit der Stromstärke I durch den Leiter 2 des Leitersystems 1, so kann das durch den elektrischen Strom erzeugte elektromagnetische Feld 4 auf die magnetisch suszeptiblen Teile des Leitersystems 1, beispielsweise dem Leiter 2 oder Teile der Ummantelung 3 wirken und diese in Schwingungen versetzen, wodurch eine Schallquelle entsteht, die Schallwellen 7, im Nachfolgenden auch kurz Schall 7 genannt, aussendet. In einer besonderen Ausführungsform kann im erfindungsgemäßen Verfahren der Schall 7 den in der Ummantelung 3 und/oder einer anderen Komponente erzeugten Körperschall und/oder Schallwellen in einem festen und/oder flüssigen und/oder gasförmigen Trägermedium umfassen.

Erfindungsgemäß ist ein Detektionsmittel 5 umfasst, welches in FIG. 6 beispielhaft dargestellt ist, um einen mit dem Vorhandensein des elektrischen Stroms verbundenen physikalischen Effekt zu detektieren. In einer Ausführungsform kann das erfindungsgemäße Verfahren eine berührungslose Detektion umfassen und das Detektionsmittel 5 mit dem Leitersystem 1 nicht in direktem Kontakt stehen.

In einer Ausführungsform kann die Detektion des mit dem Vorhandensein des elektrischen Stroms verbundenen physikalischen Effektes die Detektion eines elektromagnetischen und/oder elektrischen und/oder magnetischen Feldes umfassen und in einer besonderen Ausführungsform das Detektionsmittel 5 ein berührungsloses Mess-System wie ein Stromortungsgerät, einen Stromsensor oder einen Zangenstrommesser umfassen.

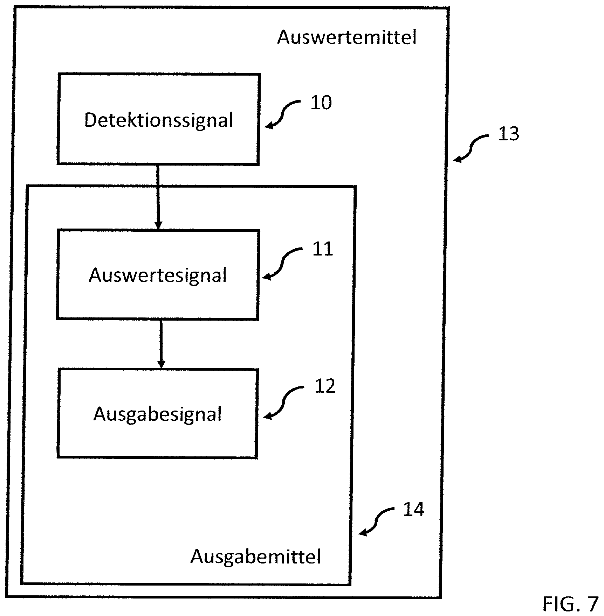

Erfindungsgemäß ist ferner, wie in FIG. 7, ein Auswertemittel 13 umfasst, um ein bei Vorhandensein eines elektrischen Stromes erzeugtes Detektionssignal 10 in ein Auswertesignal 11 umzuwandeln. Beispielsweise kann das Detektionssignal 10 ein induktives oder kapazitives Spannungs- und/oder Stromsignals sein, welches von den elektromagnetischen Feldern des im Leiter 2 fließenden Stromes erzeugt wird. Als Auswertemittel 13 können dann beispielsweise Drehspulmesswerke verwendet werden, die als Auswertesignal 11 einen Ausschlag einer drehbaren Spule um einen bestimmten Winkel aus einer Ausgangsstellung erzeugen, wobei der Ausschlag proportional zum induktiven oder kapazitiven Stromsignal ist. In einer anderen beispielhaften Ausführung können als Auswertemittel 13 Gleichrichter verwendet werden, wobei als Auswertesignal 11 im Falle des Messens von Wechselspannungen als Detektionssignal 10 ein Gleichrichtwert ausgegeben wird. Die genannten Verfahren finden in Geräten wie Amperemeter und Digitalmultimeter Anwendung.

In einer weiteren Ausführungsform können zur Messung sowie Erkennung von elektromagnetischen und/oder elektrischen und/oder magnetischen Feldern Messmethoden eingesetzt werden, welche eine Veränderung einer elektrischen Kapazität aufgrund des elektromagnetischen und/oder elektrischen und/oder magnetischen Feldes detektieren. In einer besonderen Ausführungsform können hierfür Kondensatoren, beispielsweise Plattenkondensatoren umfasst sein, bei welchen eine Kapazität durch das Auftreten oder Verändern des elektromagnetischen und/oder elektrischen und/oder magnetischen Feldes verändert und/oder detektiert wird. Beispielsweise kann dies im Falle von Plattenkondensatoren durch Veränderung des Abstandes der Kondensatorplatten zueinander erfolgen. In weiteren Ausführungsformen kann die kapazitiv-basierte Messung sowie Erkennung von elektromagnetischen und/oder elektrischen und/oder magnetischen Feldern mittels Drucksensoren, Abstandssensoren, Näherungsschaltern, Spaltsensoren, induktiven Sensoren, Wegsensoren oder Winkelsensoren oder mittels einer Kombination der vorgenannten Sensoren erfolgen. In einer weiteren Ausführungsform können ein oder mehrere dieser Sensoren als Mikrosysteme ausgeführt sein,

In einer weiteren beispielhaften Ausführung können zur Detektion Zangenstrommesser verwendet werden. Bei Zangenstrommessern, insbesondere bei Wechselstrom-Zangenstrommessern fungiert die Stromzange als magnetischer Messwandler/Stromwandler. Dabei bilden der feste und der bewegliche Schenkel der Zange im geschlossenen Zustand den Trafokern. Der zu messende Leiter 2 ist die Primärwicklung und die Spule im Messgerät die Sekundärwicklung. Der Strom im Leiter 2 magnetisiert den Kern und induziert dadurch in der Sekundärwicklung als Detektionssignal 10 einen Strom, der proportional zum Leiterstrom im Leiter 2 ist. Die Ausgangsleistung der Sekundärspule kann dann ein Dreheisenmesswerk als Auswertemittel 13 betreiben. Der bewegliche Eisenkern des Dreheisenmesswerkes dreht sich bei einer bestimmten Leistung in der Sekundärspule proportional um einen bestimmten Winkel aus seiner Ausgangsstellung, wobei der Winkel als Auswertesignal 11 verwendet werden kann.

In einer weiteren Ausführungsform können zur Detektion Hall-Sensoren zur Messung von beispielsweise einer magnetischen Flussdichte umfasst sein, welche insbesondere zur Detektion von Gleichströmen zum Einsatz kommen. In einer weiteren Ausführungsform können die Hall-Sensoren als Mikrosysteme ausgeführt sein.

In einer Ausführungsform kann umfasst sein, das Auswertesignal 11 drahtlos zu senden, zu übertragen und zu empfangen, beispielsweise mittels einem auf Bluetooth basierendem Übertragungssystem. In einer weiteren Ausführungsform kann das Auswertesignal 11 eine berechnete Stromstärke und/oder berechnete Stromspannung umfassen, welche den zu detektierenden Strom in Leiter 2 in seinen physikalischen Eigenschaften wie Stromstärke oder Spannung charakterisieren kann. In einer weiteren Ausführungsform kann das Auswertesignal 11 eine berechnete elektrische Feldstärke (in einschlägiger Fachliteratur für gewöhnlich bezeichnet mit E), eine berechnete magnetische Feldstärke (in einschlägiger Fachliteratur für gewöhnlich bezeichnet mit H) oder eine berechnete magnetische Flussdichte (in einschlägiger Fachliteratur für gewöhnlich bezeichnet mit B) oder mehrere dieser Größe umfassen. In einer Ausführungsform kann das Ausgabesignal 12 ein Schallsignal und/oder ein optisches Signal und/oder ein Textsignal und/oder ein haptisches Signal umfassen. In einer weiteren Ausführungsform kann als Detektionsmittel 5 ein Mikrophon und/oder ein Mikrosystem und/oder als Ausgabemittel 14 ein Lautsprecher und/oder Bildschirm und/oder Leuchtmittel und/oder Mittel zum Erzeugen eines haptischen Signals umfasst sein.

Erfindungsgemäß ist ein Ausgabemittel 14 umfasst, um das Auswertesignal 11 in ein Ausgabesignal 12 umzuwandeln. Beispielhaft kann des Ausgabemittel 14 eine Digitalanzeige umfassen, um als Ausgabesignal 12 eine alphanumerische Darstellung auszugeben, wobei zuvor das Auswertesignal 11, etwa der vorgenannte Gleichrichtwert, durch die hierfür vorgesehenen elektronischen Verarbeitungseinheiten des Digitalmultimeters in ein für eine alphanumerische Darstellung geeignetes Ausgabesignal 12 umgewandelt worden ist. In anderen beispielhaften Ausführungsformen umfasst das Ausgabemittel 14 eine Skala oder Spiegelskala, um einen zum Detektionssignal 10 proportionalen Winkelausschlag eines Zeigers anzuzeigen. Um weiteren beispielhaften Ausführungsformen umfasst das Ausgabesignal 12 ein Tonsignal und das Ausgabemittel 14 einen Lautsprecher.

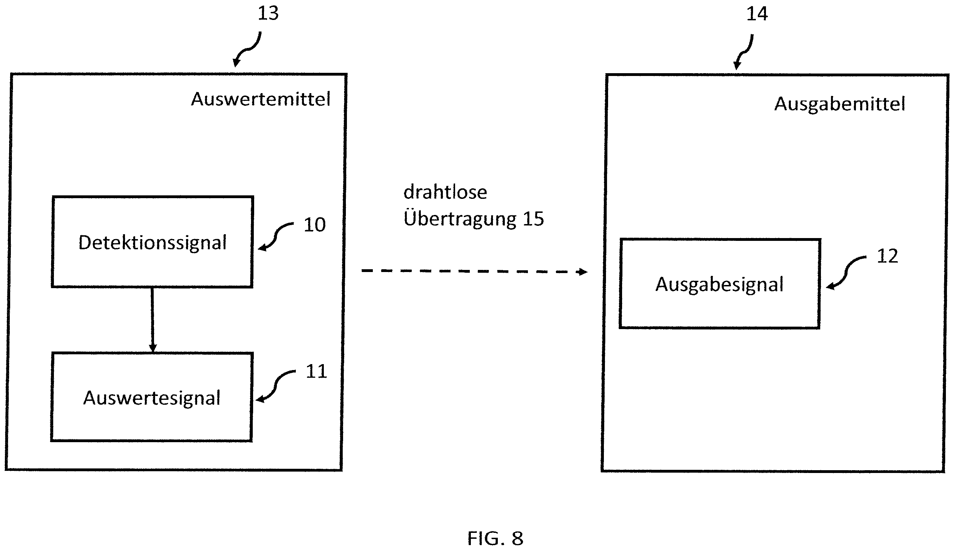

In einer beispielhaften und in FIG. 8 dargestellten Ausführungsform können das Auswertemittel 13 und das Ausgabemitte 14 in getrennten Einheiten umfasst sein, um so eine räumliche Trennung vom Ort der Messung des elektrischen Stroms in Leiter 2 und dem Ort für die Ausgabe des Ausgabesignals 12 zu ermöglichen. So können etwa bei Einrichtungen, in welchen Starkstrom zum Einsatz kommt, wie etwa Stromgeneratoren, Transformatoren oder Stromleitungen Lautsprecher zum Ausgeben eines Tonsignals als Ausgabesignal 12 bereits in größeren Entfernungen von potentiellen Gefahrenstellen wie etwa Transformatoren aufgestellt sein, um bei unvorhergesehenen Ereignissen wie technischen Defekten eine Warnung an das technische Personal auszugeben. In einer Ausführungsform kann das Auswertesignal 11 drahtlos 15 von dem Auswertemittel 13 zu dem Ausgabemittel 14 übertragen werden. Hierzu kann das Auswertesignal 11 in ein Signal umgewandelt werden, welches für die Übertragung beispielsweise mittels Funkwellen geeignet ist. In anderen Ausführungsformen kann die Übertragung mittels Infrarot-Wellen oder Laserstrahlung erfolgen.

Erfindungsgemäß ist die Detektion eines mit dem Vorhandensein des elektrischen Stromes verbundenen Schalls 7 umfasst. Wie vorgenannt beschrieben, kann elektrischer Strom als Quelle von Schall 7 fungieren, wobei der Schall Körperschall und/oder Schallwellen in einem festen und/oder flüssigen und/oder gasförmigen Trägermedium umfasst wobei der Körperschall den an einem elektrischen Leiter 2 oder Leitersystem 1 hervorgerufenen Körperschall umfassen kann, wobei der elektrische Leiter 2 von dem elektrischen Strom durchflossen wird. In FIG. 6 ist schematisch dargestellt, wie der elektrische Leiter 2 und damit das Leitersystem 1 durch die Wechselwirkung mit dem elektromagnetischen Feld, das durch den Leiter 2 fließenden elektrischen Strom erzeugt wird, in Schwingungen gerät. Das Leitersystem 1 wird somit zur Quelle von Körperschall. Die Schallemissionen 7 können hierbei auf einem niedrigen Intensitätsniveau erfolgen, ein spezifisches Frequenzspektrum aufweisen und von anderen akustischen Störsignalen überlagert sein.

In einer Ausführungsform ist vom Detektionsmittel 5 ein Mittel zur Detektion von Schall 6 umfasst, wie in den FIG. 6, 9 und 10 dargestellt. Das Mittel zur Detektion von Schall 6 kann ein Mikrophon, ein Kondensatormikrophon wie etwa ein Elektretmikrophon und in einer besonderen Ausführungsform ein Mikrosystem wie etwa ein mikroelektromechanisches Mikrophon (MEMS-Mikrophon) umfassen. MEMS-Mikrophone weisen geringen Abmessungen und eine geringe Leistungsaufnahme auf und können somit in kleine mobile Geräte wie Stromortungsgeräte eingebaut werden. MEMS-Mikrophone können mit einer guten Abschirmung von Störsignalen sowie einer aktiven Rausch- und Echokompensation und einer bestimmten Richtcharakteristik ausgeführt sein, was MEMS-Mikrophone zur Detektion von Schallemissionen mit geringer Intensität und einem spezifischen Frequenzspektrum geeignet macht. Wegen der kostengünstigen Produktion können diese Mikrofone massenhaft in kleinen und mobilen Geräten eingebaut werden.

Die Ausführung von MEMS-Mikrophonen kann zweierlei Weisen umfassen. In einer analogen Bauart wandelt das MEMS-Mikrophon das Schallsignal 7 in eine entsprechende analoge Ausgangsspannung als Auswertesignal 11 um, während die digitale Bauart ein digitales, in der Regel per Pulsdichtenmodulation (PDM) codiertes Ausgangssignal als Auswertesignal 11 liefert. Das MEMS-Mikrofon fungiert als akustischer Messwertumformer. Die Umformung erfolgt mithilfe von Änderungen der Koppelkapazität zwischen einer feststehenden Platte (Grundplatte) und einer beweglichen Platte (Membran). Die Kapazitätsänderungen werden durch die Schallwellen ausgelöst, die durch die Schalleintrittsöffnungen auf die Membran gelangen und diese in Bewegung versetzen, wodurch sich die Breite des Luftspalts zwischen den beiden Kondensatorplatten verändert. Die Kapazitätsänderungen sind in diesen Ausführungsbeispiel vom Detektionssignal 10 umfasst. Die rückwärtige Kammer fungiert als akustischer Resonator. Die in der rückwärtigen Kammer komprimierte Luft kann durch die Druckausgleichsöffnung entweichen, sodass sich die Membran bewegen kann.

In anderen erfindungsgemäßen Ausführungsformen kann jedes andere Mittel zur Schalldetektion 6, wie beispielsweise ein Kondensator-Mikrophon, von einem Detektionsmittel 5 umfasst sein.

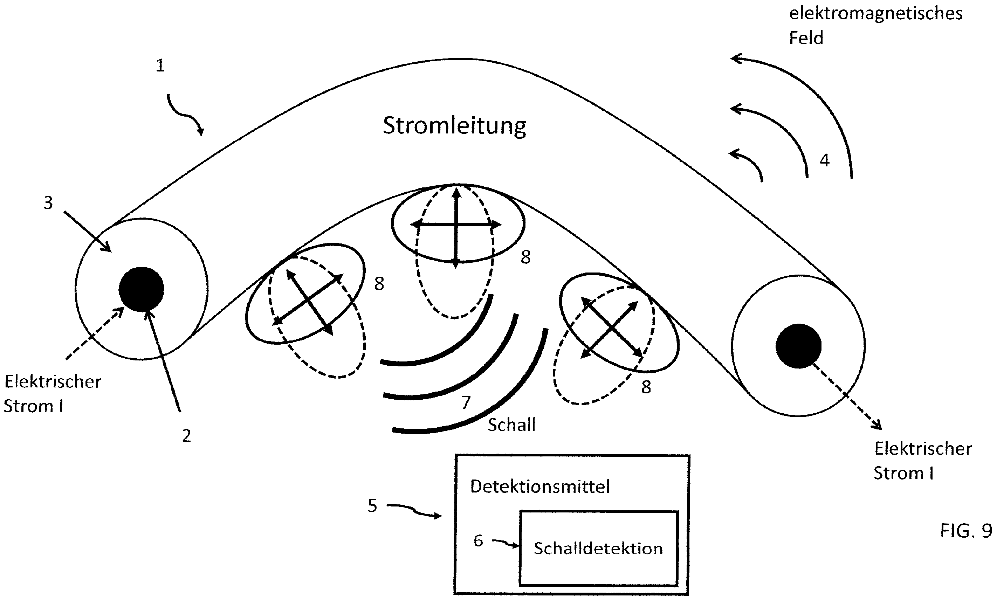

In FIG. 9 ist die Detektion von Schall 7 dargestellt, wobei der Schall 7 von am Leitersystem 1 kondensierten Wassertropfen 8 erzeugt wird, wobei die Wassertropfen 8 durch das elektromagnetische Feld 4, erzeugt vom elektrischen Strom der Stärke I im Leiter 2, in Schwingungen versetzt werden, wie in einem der vorgenannten Effekte bereits beschrieben. Nicht dargestellt ist die entsprechende Detektion von Koronarentladungen, welche ebenfalls durch an elektrischen Leitersystemen 1 kondensierter Feuchtigkeit entstehen können. Die Zuhilfenahme von Wassertopfen und Feuchtigkeit zur Stromortung kann zu einer besseren Beurteilung beitragen, ob eine Vorrichtung gerade stromführend ist und kann zum Aufspüren von unerwarteten elektrischen Strömen beitragen.

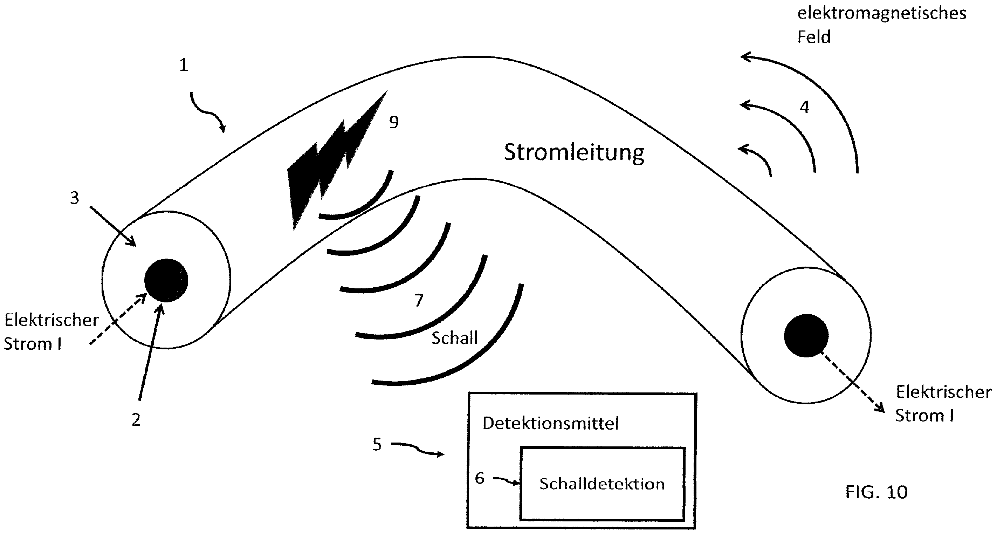

FIG. 10 zeigt in einer erfindungsgemäßen Ausführungsform die Detektion von Schall, hervorgerufen von elektrischem Strom in einem defekten Leitersystem 1. Ein Defekt 9, schematisch dargestellt in FIG. 10 kann eine strukturelle Änderung am dem Leitersystem 1 bewirken, etwa eine Veränderung in der Masse oder der Massenanordnung des Leitersystems 1, in der Anordnung der Komponenten der Leitersystems 1, in der chemischen Zusammensetzung etwa der Ummantelung 3 etc. Dies kann beispielsweise eine Änderung der Eigenfrequenzen des Leitersystems 1 zur Folge haben, so dass das Leitersystem 1 unter Einwirkung des elektromagnetischen Feldes 4 - hervorgerufen durch den Strom im Leiter 2 - bei anderen Frequenzen schwingt als im Falle, wenn kein Defekt 9 vorhanden ist. Die Körperschalleigenschaften und damit der ausgesendete Schall 7 des defekten Leitersystems 1 unterschieden sich demnach von den Körperschalleigenschaften und dem ausgesendeten Schall eines entsprechenden intakten Leitersystems 1. In einer erfindungsgemäßen Ausführungsform detektiert das Mittel zur Schalldetektion 6 die veränderten Schallemissionen 7.

Diese veränderten Schallemissionen 7 können beispielsweise dann als Grundlage dafür dienen, Schäden an einer Vorrichtung wie einer Maschine zu erkennen. Eine schallbasierte Detektion von Strömen kann somit Bestandteil einer Betriebszustandsüberwachung einer Maschine, eines Maschinenparks etc. sein.

Ein Defekt 9 kann beispielsweise aber auch zur Folge haben, dass in einer Einrichtung, welche das Leitersystem 1 umfasst - etwa in einer Maschine - in unvorhergesehener Weise Komponenten oder Systeme von Komponenten unter Strom stehen. Dies kann zu einer bisweilen extremen Gefährdung von Personen führen, wie etwa Angehörigen des Personals, das zum Betrieb und Wartung der betreffenden Maschine abgestellt ist und mit den nunmehr Strom führenden Komponenten der Maschine arglos in Berührung gerät. Die erfindungsgemäße schallbasierte Detektion von Strömen kann nun berührungslos den Schall 7 von diesen nunmehr unter Strom und deswegen unter Einwirkung eines elektromagnetischen Feldes stehenden Komponenten erfassen und zur Warnung entsprechender Personen herangezogen werden.

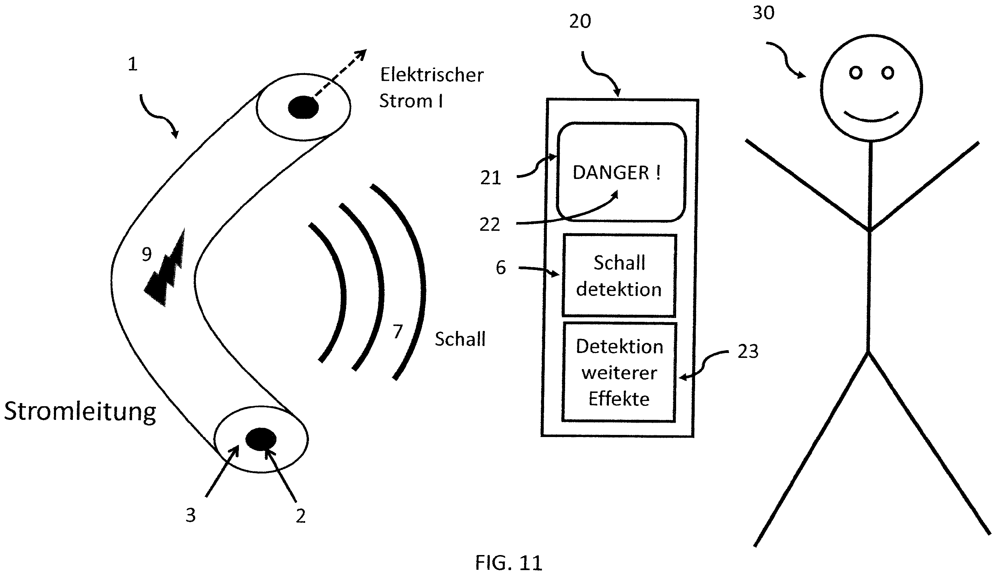

Erfindungsgemäß ist eine Vorrichtung zum schallbasierten Detektieren eines Vorhandenseins eines elektrischen Stroms in einem Sicherheitssystem, wie in FIG. 11 dargestellt, umfasst. Ein Sicherheitssystem ist in einer erfindungsgemäßen Ausführungsform ein tragbares Gerät 20, welches von einer Person 30, etwa einem Angehörigen des technischen Personals, mitgeführt wird und bei unerwartetem Auftreten von elektrischen Strömen ein Warnsignal ausgibt. In einer besonderen Ausführungsform kann das tragbare Gerät 20 von der Person 30 direkt am Körper getragen werden, beispielsweise mittels eines Armbandes oder eines Stirnbandes. In einer erfindungsgemäßen Ausführungsform umfasst das Gerät 20 als Ausgabemittel 14 einen Bildschirm 21 und als Ausgabesignal 12 ein Textsignal, in FIG. 11 beispielhaft durch das Wort "DANGER!" dargestellt, auf. Es können aber auch andere Wörter wie "GEFAHR!", "ACHTUNG!" oder "VORSICHT!" angezeigt werden. In weiteren Ausführungsformen kann ein akustisches Warnsignal, beispielsweise ein hoher Piepton oder ein haptisches Signal, etwa wenn die Person 30 das Gerät 20 direkt am Körper trägt, ausgegeben werden. In einer anderen Ausführungsform können auch mehrere verschiedene Warnsignale redundant ausgegeben werden.

In einer weiteren Ausführungsform kann das Gerät 20 ein Smartphone oder eine Smartwatch umfassen, welche das Auswertesignal 11 mittels einem auf Bluetooth basierendem Übertragungssystem empfängt und auf einem Bildschirm 21 als Ausgabesignal 12 beispielsweise ein oben beschriebenes Textsignal oder jedes andere geeignete Warnsignal ausgibt.

In einer weiteren Ausführungsform können die erfindungsgemäßen Systeme zur schallbasierten Detektion von Strom auch mit künstlicher Intelligenz ausgestattet sein. Ereignisse sowie deren Umstände, in denen Strom detektiert worden ist, werden gespeichert und mit Methoden der künstlichen Intelligenz ausgewertet. Auf diese Weise gewonnene Parameter können dann bei der Beurteilung der Gefährdungslage von zukünftigen Situationen, bei denen die Gefahr von unerwartet auftretenden Strömen besteht, herangezogen werden.

Das in Figur 11 dargestellte tragbare Gerät umfasst neben dem Mittel zur Schalldetektion 6 noch weitere Mittel 23 zur Detektion anderer, durch den elektrischen Strom I im Leiter 2 verursachte Effekte, beispielsweise eines elektromagnetischen Feldes. Wird durch mindestens einer dieser vorgenannten Mittel ein Signal detektiert, welches über einer vordefinierten Schwelle liegt, bei welcher einer Warnung ausgegeben werden soll, so wird dem Ausgabemittel 14, in diesem Falle der Bildschirm 21 ein Kommando zur Ausgabe des Warnsignales "DANGER!" gegeben. Die Schalldetektion 6 ergänzt in dieser Ausführungsform bereits bestehende Detektionssystems des tragbaren Gerätes 20, beispielsweise eines Stromortungsgerätes, eines Stromsensors oder reines Zangenstromessers,

### Bezugszeichenliste

- 1: elektrisches Leitersystem
- 2: Leiter
- 3: Ummantelung
- 4: elektromagnetisches Feld
- 5: Detektionsmittel
- 6: Mittel zur Schalldetektion
- 7: Schall / Schallemission
- 8: Wassertropfen
- 9: Defekt (schematische Darstellung)
- 10: Detektionssignal
- 11: Auswertesignal
- 12: Ausgabesignal
- 13: Auswertemittel
- 14: Ausgabemittel
- 15: drahtlose Übertragung
- 20: tragbares Gerät
- 21: Bildschirm
- 22: Textsignal
- 23: Mittel zur Detektion weiterer Effekte
- 30: Person

## Patentansprüche

1. Verfahren zum Detektieren eines Vorhandenseins eines elektrischen Stroms und/oder einer elektrischen Spannung, umfassend
Bereitstellen eines Detektionsmittels (5), um einen mit dem Vorhandensein des elektrischen Stroms und/oder der elektrischen Spannung verbundenen physikalischen Effekt zu detektieren;
Bereitstellen eines Auswertemittels (13), um ein bei Vorhandensein eines elektrischen Stromes und/oder elektrischen Spannung erzeugtes Detektionssignal (10) in ein Auswertesignal (11) umzuwandeln;
Bereitstellen eines Ausgabemittels (14), um das Auswertesignal (11) in ein Ausgabesignal (12) umzuwandeln;
wobei das Verfahren die Detektion (6) eines mit dem Vorhandensein des elektrischen Stromes und/oder der elektrischen Spannung verbundenen Schalls (7) umfasst,
der Schall Körperschall umfasst, und
das Verfahren eine berührungslose Detektion umfasst;
**gekennzeichnet dadurch:**
**dass** das Detektionsmittel (5) und das Ausgabemittel (14) von einem tragbaren Gerät (20) umfasst sind.

2. Verfahren nach Anspruch 1, wobei der Schall Schallwellen in einem festen und/oder flüssigen und/oder gasförmigen Trägermedium umfasst.

3. Verfahren, nach Anspruch 2, wobei der Körperschall den an einem elektrischen Leiter hervorgerufenen Körperschall umfasst, wobei der elektrische Leiter von dem elektrischen Strom durchflossen wird.

4. Verfahren nach einem der vorhergehenden Ansprüche, wobei die Detektion des mit dem Vorhandensein des elektrischen Stroms und/oder der elektrischen Spannung verbundenen physikalischen Effektes die Detektion eines elektromagnetischen (4) und/oder elektrischen und/oder magnetischen Feldes umfasst.

5. Verfahren nach einem der vorhergehenden Ansprüche, wobei als Detektionsmittel ein Mikrophon und/oder ein Mikrosystem und/oder als Ausgabemittel ein Lautsprecher und/oder Bildschirm (21) und/oder Leuchtmittel und/oder Mittel zum Erzeugen eines haptischen Signals bereitgestellt wird.

6. Verfahren nach einem der vorhergehenden Ansprüche, wobei das Auswertesignal (11) drahtlos gesendet, übertragen und empfangen (15) wird und/oder das Auswertesignal (11) eine berechnete Stromstärke und/oder berechnete Stromspannung und/oder eine elektrische und/oder magnetische Feldstärke und/oder eine elektrische und/oder magnetische Flussdichte umfasst und/oder das Ausgabesignal (12) ein Schallsignal und/oder ein optisches Signal und/oder ein Textsignal und/oder ein haptisches Signal umfasst.

7. Tragbares Gerät (20) umfassend eine Vorrichtung zum Detektieren eines Vorhandenseins eines elektrischen Stroms und/oder einer elektrischen Spannung, wobei die Vorrichtung aufweist:
ein Detektionsmittel (5), dass ausgebildet und eingerichtet ist, um einen mit dem Vorhandensein eines elektrischen Stroms und/oder einer elektrischen Spannung erzeugten Körperschall zu detektieren;
ein Auswertemittel (13), dass ausgebildet und eingerichtet ist, um ein bei Vorhandensein eines elektrischen Stromes und/oder einer elektrischen Spannung erzeugtes Detektionssignal (10) in ein Auswertesignal (11) umzuwandeln; und
ein Ausgabemittel (14), dass ausgebildet und eingerichtet ist, um das Auswertesignal (11) in ein Ausgabesignal (12) umzuwandeln;
wobei das Detektionsmittel (5) so ausgebildet und eingerichtet ist, um eine berührungslose Detektion eines Vorhandenseins eines elektrischen Stroms und/oder einer elektrischen Spannung bereitzustellen.

8. Tragbares Gerät (20) nach Anspruch 7, wobei der Körperschall solche Schallwellen umfasst, die in einem festen und/oder flüssigen und/oder gasförmigen Trägermedium erzeugt werden.

9. Tragbares Gerät (20) nach Anspruch 8, wobei der Körperschall die von einem elektrischen Leiter hervorgerufenen Schallwellen umfasst, der von dem elektrischen Strom durchflossen wird.

10. Tragbares Gerät (20) nach einem der Ansprüche 7 bis 9, wobei das Detektionsmittel (5) so eingerichtet ist, ein mit dem Vorhandensein des elektrischen Stroms und/oder elektrischen Spannung verbundenes elektromagnetisches und/oder elektrisches und/oder magnetisches Feld zu detektieren.

11. Tragbares Gerät (20) nach einem der Ansprüche 7 bis 10, wobei das Detektionsmittel (5) ein Mikrophon und/oder ein Mikrosystem und/oder das Ausgabemittel (14) einen Lautsprecher und/oder Bildschirm (21) und/oder Leuchtmittel und/oder Mittel zum Erzeugen eines haptischen Signals umfasst.

12. Tragbares Gerät (20) nach einem der Ansprüche, wobei das Auswertemittel (13) und das Ausgabemittel (14) so eingerichtet sind, das Auswertesignal (11) drahtlos zu senden, zu übertragen und zu empfangen (15) und/oder eine Stromstärke und/oder eine Stromspannung und/oder eine elektrische und/oder magnetische Feldstärke und/oder eine elektrische und/oder magnetische Flussdichte zu berechnen und/oder das Ausgabemittel (14) so eingerichtet ist, als Ausgabesignal (12) ein Schallsignal und/oder ein optisches Signal und/oder ein Textsignal und/oder ein haptisches Signal zu erzeugen.

13. Arbeitsschutzvorrichtung zum Ausgeben eines Warnsignals, umfassend ein tragbares Gerät (20) nach einem der Ansprüche 7 bis 12, wobei das Warnsignal das Ausgabesignal (12) umfasst.

## Claims

1. A method for detecting the presence of an electrical current and/or voltage, comprising
providing a detection means (5) to detect a physical effect associated with the presence of the electrical current and/or voltage;
providing an evaluation means (13) for converting a detection signal (10) generated in the presence of an electrical current and/or electrical voltage into an evaluation signal (11);
providing an output means (14) for converting the evaluation signal (11) into an output signal (12);
wherein the method comprises the detection (6) of a sound (7) associated with the presence of the electrical current and/or the electrical voltage,
the sound comprises body sound, and
the method comprises non-contact detection;
**characterized in that**:
the detection means (5) and the output means (14) are comprised by a portable apparatus (20).

2. The method according to claim 1, wherein the sound comprises acoustic waves in a solid and/or liquid and/or gaseous carrier medium.

3. The method according to claim 2, wherein the body sound comprises the body sound caused at an electrical conductor, wherein the electrical current flows through the electrical conductor.

4. The method according to any of the preceding claims, wherein the detection of the physical effect associated with the presence of the electrical current and/or voltage comprises the detection of an electromagnetic (4) and/or electric and/or magnetic field.

5. The method according to any of the preceding claims, wherein a microphone and/or a microsystem is provided as the detection means and/or a loudspeaker and/or a display screen (21) and/or light means and/or means for generating a haptic signal are provided as the output means.

6. The method according to any of the preceding claims, wherein the evaluation signal (11) is transmitted wirelessly and received (15) and/or the evaluation signal (11) comprises a calculated current strength and/or calculated current voltage and/or an electric and/or magnetic field strength and/or an electric and/or magnetic flow density and/or the output signal (12) comprises an acoustic signal and/or an optical signal and/or a text signal and/or a haptic signal.

7. A portable apparatus (20) comprising a device for detecting the presence of an electrical current and/or voltage, wherein the device has:
a detection means (5) designed and configured to detect a body sound generated by the presence of an electrical current and/or voltage;
an evaluation means (13) that is designed and configured to convert a detection signal (10) generated in the presence of an electrical current and/or an electrical voltage into an evaluation signal (11); and
an output means (14) designed and configured to convert the evaluation signal (11) into an output signal (12);
wherein the detection means (5) is designed and configured to provide non-contact detection of the presence of an electrical current and/or voltage.

8. The portable apparatus (20) according to claim 7, wherein the body sound comprises acoustic waves that are generated in a solid and/or liquid and/or gaseous carrier medium.

9. The portable apparatus (20) according to claim 8, wherein the body sound comprises the acoustic waves caused by an electrical conductor through which the electrical current flows.

10. The portable apparatus (20) according to any of claims 7 to 9, wherein the detection means (5) is configured to detect an electromagnetic and/or electric and/or magnetic field associated with the presence of the electrical current and/or voltage.

11. The portable apparatus (20) according to any of claims 7 to 10, wherein the detection means (5) comprises a microphone and/or a microsystem and/or the output means (14) comprises a loudspeaker and/or a display (21) and/or light means and/or means for generating a haptic signal.

12. The portable apparatus (20) according to any of the claims, wherein the evaluation means (13) and the output means (14) are configured to wirelessly send, transmit and receive (15) the evaluation signal (11) and/or to calculate a current strength and/or a voltage strength and/or an electric and/or magnetic field strength and/or an electric and/or magnetic flow density and/or to calculate the output signal (12) as an output means (14) is configured to generate an acoustic signal and/or an optical signal and/or a text signal and/or a haptic signal.

13. An industrial safety apparatus for emitting a warning signal, comprising a portable apparatus (20) according to any of claims 7 to 12, wherein the warning signal comprises the output signal (12).

## Revendications

1. Procédé de détection de la présence d'un courant électrique et/ou d'une tension électrique, comprenant
la mise à disposition d'un moyen de détection (5) pour détecter un effet physique lié à la présence du courant électrique et/ou de la tension électrique ;
la mise à disposition d'un moyen d'évaluation (13) pour convertir un signal de détection (10) généré en présence d'un courant électrique et/ou d'une tension électrique en un signal d'évaluation (11) ;
la mise à disposition d'un moyen de sortie (14) pour convertir le signal d'évaluation (11) en un signal de sortie (12) ;
dans lequel le procédé comprend la détection (6) d'un son (7) lié à la présence du courant électrique et/ou de la tension électrique,
le son comprend du bruit structurel, et
le procédé comprend une détection sans contact ;
**caractérisé en ce :**
**que** le moyen de détection (5) et le moyen de sortie (14) sont compris par un appareil portatif (20).

2. Procédé selon la revendication 1, dans lequel le son comprend des ondes sonores dans un fluide de support solide et/ou liquide et/ou gazeux.

3. Procédé selon la revendication 2, dans lequel le bruit structurel comprend le bruit structurel provoqué sur un conducteur électrique, dans lequel le conducteur électrique est traversé par le courant électrique.

4. Procédé selon l'une quelconque des revendications précédentes, dans lequel la détection de l'effet physique lié à la présence du courant électrique et/ou de la tension électrique comprend la détection d'un champ électromagnétique (4) et/ou électrique et/ou magnétique.

5. Procédé selon l'une quelconque des revendications précédentes, dans lequel sont fournis, en tant que moyen de détection, un microphone et/ou un microsystème et/ou, en tant que moyen de sortie, un haut-parleur et/ou un écran (21) et/ou des moyens d'éclairage et/ou des moyens de génération d'un signal haptique.

6. Procédé selon l'une quelconque des revendications précédentes, dans lequel le signal d'évaluation (11) est envoyé, transmis et reçu (15) sans fil et/ou le signal d'évaluation (11) comprend une intensité de courant calculée et/ou une tension de courant calculée et/ou une intensité de champ électrique et/ou magnétique et/ou une densité de flux électrique et/ou magnétique et/ou le signal de sortie (12) comprend un signal sonore et/ou un signal optique et/ou un signal textuel et/ou un signal haptique.

7. Appareil portatif (20) comprenant un dispositif de détection de la présence d'un courant électrique et/ou d'une tension électrique, dans lequel le dispositif présente :
un moyen de détection (5), qui est réalisé et mis au point pour détecter un bruit structurel généré en présence d'un courant électrique et/ou d'une tension électrique ;
un moyen d'évaluation (13), qui est réalisé et mis au point pour convertir un signal de détection (10) généré en présence d'un courant électrique et/ou d'une tension électrique en un signal d'évaluation (11) ; et
un moyen de sortie (14), qui est réalisé et mis au point pour convertir le signal d'évaluation (11) en un signal de sortie (12) ;
dans lequel le moyen de détection (5) est réalisé et mis au point pour fournir une détection sans contact de la présence d'un courant électrique et/ou d'une tension électrique.

8. Appareil portatif (20) selon la revendication 7, dans lequel le bruit structurel comprend des ondes sonores, qui sont générées dans un fluide de support solide et/ou liquide et/ou gazeux.

9. Appareil portatif (20) selon la revendication 8, dans lequel le bruit structurel comprend les ondes sonores provoquées par un conducteur électrique, qui est traversé par le courant électrique.

10. Appareil portatif (20) selon l'une quelconque des revendications 7 à 9, dans lequel le moyen de détection (5) est mis au point pour détecter un champ électromagnétique et/ou électrique et/ou magnétique lié à la présence du courant électrique et/ou de la tension électrique.

11. Appareil portatif (20) selon l'une quelconque des revendications 7 à 10, dans lequel le moyen de détection (5) comprend un microphone et/ou un microsystème et/ou le moyen de sortie (14) comprend un haut-parleur et/ou un écran (21) et/ou des moyens d'éclairage et/ou des moyens de génération d'un signal haptique.

12. Appareil portatif (20) selon l'une quelconque des revendications, dans lequel le moyen d'évaluation (13) et le moyen de sortie (14) sont mis au point pour envoyer, transmettre et recevoir sans fil (15) le signal d'évaluation (11) et/ou pour calculer une intensité de courant et/ou une tension de courant et/ou une intensité de champ électrique et/ou magnétique et/ou une densité de flux électrique et/ou magnétique et/ou le moyen de sortie (14) est mis au point pour générer en tant que signal de sortie (12) un signal sonore et/ou un signal optique et/ou un signal textuel et/ou un signal haptique.

13. Dispositif de protection du travail pour émettre un signal d'avertissement, comprenant un appareil portatif (20) selon l'une quelconque des revendications 7 à 12, dans lequel le signal d'avertissement comprend le signal de sortie (12).
